(19) Europäisches Patentamt

European Patent Office

Office européen des brevets

(11) **EP 1 308 931 A1**

(12) **EUROPÄISCHE PATENTANMELDUNG**

(43) Veröffentlichungstag:
07.05.2003 Patentblatt 2003/19

(51) Int Cl.$^7$: **G10L 19/14**

(21) Anmeldenummer: **02090082.5**

(22) Anmeldetag: **01.03.2002**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (72) Erfinder:<br>• **Schröder, Ernst F.**<br>  **30655 Hannover (DE)**<br>• **Böhm, Johannes**<br>  **37083 Göttingen (DE)** |
| (30) Priorität: **23.10.2001 EP 01250372** | (74) Vertreter: **Hartnack, Wolfgang, Dipl.-Ing.**<br>**Deutsche Thomson-Brandt GmbH**<br>**European Patent Operations**<br>**Karl-Wiechert-Allee 74**<br>**30625 Hannover (DE)** |
| (71) Anmelder: **DEUTSCHE THOMSON-BRANDT GMBH**<br>**78048 Villingen-Schwenningen (DE)** | |

(54) **Decodierung eines codierten digitalen Audio-Signals welches in Header enthaltende Rahmen angeordnet ist**

(57) Bei der Audio-Datenreduzierung nach Standard ISO/IEC 11172-3 wird bei einer Abtastfrequenz von 44,1kHz eine um 8 Bit variierende Rahmenlänge verwendet, um im Mittel auf eine bestimmte feste Datenrate zu kommen. Die Verlängerung eines Datenrahmens wird durch ein Padding-Bit im Header der Rahmen signalisiert. Erfindungsgemäß wird auf die Auswertung des Padding-Bits verzichtet. Stattdessen wird die mittlere Rahmenlänge L berechnet, L auf die nächste ganze Zahl abgerundet, beim nachfolgenden Rahmen zunächst festgestellt, ob das erwartete Syncwort dieses Rahmens auftritt und wenn dies zutrifft, dieser Rahmen ohne Berücksichtigung des Padding-Bits decodiert, wenn aber das erwartete Syncwort dieses Rahmens nicht auftritt, wird die Decodierung des Rahmens ohne Berücksichtigung des Padding-Bits eine 8 Bit später begonnen.

Fig.2

EP 1 308 931 A1

**Beschreibung**

Die Erfindung betrifft ein Verfahren und eine Vorrichtung zur Decodierung eines codierten digitalen Audio-Signals welches in Header enthaltende Rahmen angeordnet ist.

Stand der Technik

Bei Anwendung der Audio-Datenreduzierung nach Standard ISO/IEC 11172-3 und 13818-3 wird bei einer Abtastfrequenz von 44,1kHz eine um 8 Bit variierende Rahmenlänge verwendet, um im Mittel auf eine bestimmte feste Datenrate (z.B. 128000 bit/sec) zu kommen. Die 'Verlängerung' eines Datenrahmens oder Frames wird durch das sogenannte Padding-Bit im Header eines Frames signalisiert. Genauer beschrieben ist dieses Verfahren in EP-A-0402973. Die Rahmen enthalten zu Beginn auch noch ein Sync-Wort.

Erfindung

Die Auswertung dieses Padding-Bits im Decoder kann zu Schwierigkeiten führen. Es ist z.B. in hochoptimierten Decodern in den darin enthaltenen digitalen Signalprozessoren (DSP) erforderlich, sehr sparsam mit Speicherplatz umzugehen. Da aber der Header eines Rahmens am Anfang der Dekodierung des Rahmens gelesen wird, der Wert des Padding-Bits aber erst ganz am Ende des Dekodierens dieses Rahmens benötigt wird, wird typischerweise in einer DSP-Implementierung eine ganze Speicherstelle (ein Integer-Wert von z.B. mehreren Byte Länge) verschwendet, nur um den Wert des Padding-Bits aufzubewahren.
Eine Verringerung des benötigten Speicherplatzes könnte durch Verzicht auf das 'Padding' erreicht werden, d.h. die Rahmenlängen würden auch bei einer Abtastfrequenz von 44.1kHz immer konstant gehalten. Man erhält dann allerdings nicht mehr eine bestimmte feste Datenrate von z.B. 128000 bit/sec, sondern einen um 0,23% geringeren Wert. Ein Decoder, der sich darauf verlässt, dass auch bei 44.1kHz Abtastfrequenz immer eine konstante Rahmenlänge verwendet wird, wäre aber nicht mehr kompatibel zum obengenannten ISO/IEC Standard.

Der Erfindung liegt die Aufgabe zugrunde, ein Verfahren anzugeben bei dem man mit weniger Speicherplatz auskommt aber die Kompatibilität zu den Standards ISO/IEC 11172-3 und 13818-3 oder ähnlichen Standards erhalten bleibt. Diese Aufgabe wird durch das in Anspruch 1 angegebene Verfahren gelöst. Ein Decoder, welcher dieses Verfahren benutzt, ist in Anspruch 5 angegeben.

Erfindungsgemäß werden die in ihrer Länge variierenden Datenrahmen entsprechend der jeweiligen Länge ausgewertet, aber die Auswertung des Padding-Bits aus dem Header wird vermieden. Da der Wert des Padding-Bits normalerweise dazu verwendet wird, die genaue Lage des Beginns des nächsten Rahmens zu ermitteln, wird erfindungsgemäß der Beginn des nächsten Rahmens auf andere Weise ermittelt, nämlich durch Berechnung einer mittleren Rahmenlänge und einer Abrundung oder Aufrundung dieser mittleren Rahmenlänge auf die nächstliegenden ganzzahligen Byte-Werte der empfangenen Rahmen.

Der Vorteil liegt darin, dass der Wert des Padding-Bits nicht während der gesamtem Zeitdauer der Dekodierung eines Rahmens gespeichert werden muss und somit knapper Speicherplatz eingespart werden kann.

Im Prinzip betrifft das erfindungsgemäße Verfahren die Decodierung eines codierten digitalen Audio-Signals welches in Header enthaltende Rahmen angeordnet ist, wobei der Header eines Rahmens jeweils eine Information darüber enthält, ob dieser Rahmen eine Standard-Länge oder eine bei manchen der Rahmen davon abweichender Länge hat, und wobei die Rahmen jeweils ein Syncwort enthalten, mit folgenden Schritten:

- die Längenvariations-Information über die jeweilige Rahmenlänge wird nicht gespeichert oder ausgewertet;
- der ungefähre Beginn des nächsten Rahmens wird anhand der folgenden Formel bestimmt:

$$L = N * R / fs / SL,$$

  mit L gleich Länge der Rahmen, N gleich Anzahl der Abtastwerte pro Rahmen, R gleich Gesamt-Datenrate, fs gleich Abtastfrequenz, SL gleich festgelegte Unter-Einheit für die Angabe der Rahmenlänge;
- L wird auf die nächste ganze Zahl von Unter-Einheiten SL abgerundet;
- beim nachfolgenden Rahmen wird zunächst festgestellt, ob das erwartete Syncwort dieses Rahmens auftritt;
- wenn das erwartete Syncwort dieses Rahmens auftritt, wird dieser nachfolgende Rahmen ohne Berücksichtigung der Längenvariations-Information decodiert;
- wenn das erwartete Syncwort dieses Rahmens nicht auftritt, wird die Decodierung dieses nachfolgenden Rahmens ohne Berücksichtigung der Längenvariations-Information eine Unter-Einheit SL später begonnen.

Im Prinzip betrifft die erfindungsgemäße Vorrichtung einen Decoder zur Decodierung eines codierten digitalen Audio-Signals welches in Header enthaltende Rahmen angeordnet ist, wobei der Header eines Rahmens jeweils eine Information darüber enthält, ob dieser Rahmen eine Standard-Länge oder eine bei manchen der Rahmen davon abweichender Länge hat, und die Rahmen jeweils ein Syncwort enthalten, wobei für die Ermittlung der Rahmenlänge die Längenvariations-Information über die jeweilige Rahmenlänge nicht gespeichert oder ausgewertet wird und wobei die Vorrichtung enthält:

- Mittel zur Decodierung des Audio-Signals;
- einen Rahmenstart-Schätzer in dem der ungefähre Beginn des nächsten Rahmens anhand der folgenden Formel bestimmt wird:

$$L = N * R / fs / SL,$$

mit L gleich Länge der Rahmen, N gleich Anzahl der Abtastwerte pro Rahmen, R gleich Gesamt-Datenrate, fs gleich Abtastfrequenz, SL gleich festgelegte Unter-Einheit,
und in dem L auf die nächste ganze Zahl von Unter-Einheiten SL abgerundet wird;
- einen Synchwort-Checker, der beim nachfolgenden Rahmen zunächst feststellt, ob das erwartete Syncwort dieses Rahmens auftritt, wobei, wenn das erwartete Syncwort dieses Rahmens auftritt, dieser nachfolgende Rahmen ohne Berücksichtigung der Längenvariations-Information in den Decodierungs-Mitteln decodiert wird, und wenn das erwartete Syncwort dieses Rahmens nicht auftritt, die Decodierung dieses nachfolgenden Rahmens ohne Berücksichtigung der Längenvariations-Information in den Decodierungs-Mitteln eine Unter-Einheit SL später begonnen wird.

Statt der Auswertung des Syncworts kann auch ein anderes bekanntes und erwartetes Datenmuster ausgewertet werden.

Zeichnungen

Anhand der Zeichnungen sind Ausführungs-Beispiele der Erfindung beschrieben. Diese zeigen in:

Fig. 1    zwei aufeinanderfolgende Datenrahmen mit gleicher Länge;
Fig. 2    zwei aufeinanderfolgende Datenrahmen mit verschiedener Länge;
Fig. 3    erfindungsgemäßer Decoder.

Ausführungs-Beispiele

In datenreduzierenden Codier- bzw. Decodier-Verfahren für Audiosignale wie z.B. in ISO/IEC 11172-3 (MPEG Audio) werden die codierten Audiosignale in Datenrahmen gespeichert oder übertragen, die jeweils eine feste Anzahl N von Audio-Abtastwerten enthalten, z.B. 1152 Abtastwerte. Die Datenrahmen haben im Prinzip eine feste Länge die ein Vielfaches einer Grundeinheit ist, welche in ISO/IEC 11172-3 'Slot' genannt wird und die bei den Varianten 'Layer 2' und 'Layer 3' eine Länge von 8 bit aufweist.

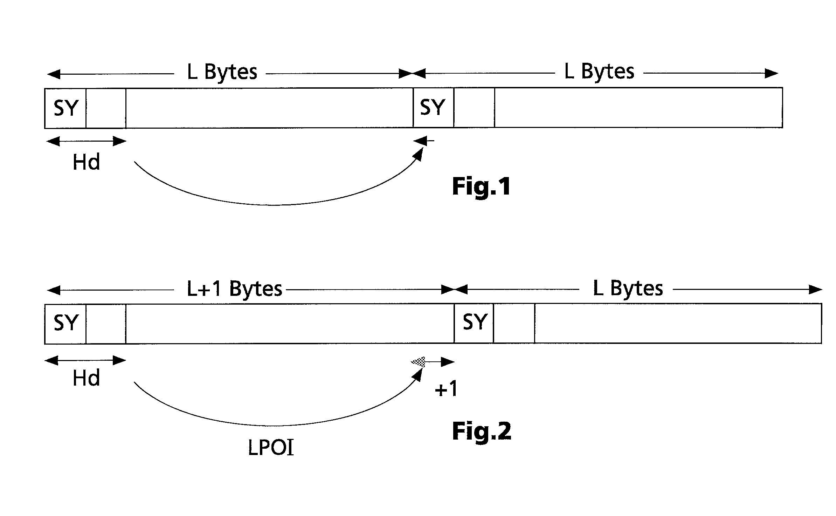

In Fig. 1 verfügt jeder der aufeinanderfolgenden Rahmen gleicher Länge von L Bytes über einen Header Hd, der ein Syncwort SY enthält. Die Größe der Untereinheit SL ist in diesem Beispiel 1 Byte = 8 bit.

Verwendet man Audiosignale mit Abtastfrequenzen fs von 32000Hz oder 48000Hz, so ist die Beziehung zwischen der Gesamt-Datenrate R (in bit/sec) und der Rahmenlänge L (in Slots) gegeben:

$$L = N * R / fs / 8 \qquad (1)$$

Beispiel:

N = 1152 Abtastwerte; R = 128000 bit/sec; fs = 48000Hz ergibt L = 384 Slots ä 8 bit.

Wird aber eine Abtastfrequenz von 44100Hz verwendet, so ergeben sich in (1) nicht-ganzzahlige Werte für L. Auf diese Weise wird der Beginn des nächsten Rahmens nur näherungsweise bestimmt. Beispiel: N = 1152 Abtastwerte; R = 128000 bit/sec; fs = 44100Hz ergibt L = 417,9591837 Slots ä 8 bit.

Da ein Rahmen aber nur eine ganzzahlige Anzahl von Slots aufweisen kann, wird bei einer Abtastfrequenz von 44,1kHz eine um 1 Slot (= 8 bit) variierende Rahmenlänge verwendet, um im Mittel auf eine bestimmte feste Datenrate (z.B. R = 128 000 bit/sec) zu kommen und wie oben beschrieben mittels des Padding-Bits im Header signalisiert.

Bei Abwärtsrundung des Ergebnisses aus Formel (1) erhält man für 44,1kHz Abtastfrequenz oft den richtigen Rahmen-Anfang, nämlich für solche Rahmen, die nicht um 1 Slot verlängert wurden. Oft erhält man aber auch einen falschen Wert für den Rahmen-Anfang. Beginnt man an dieser falschen Stelle damit, den folgenden Rahmen zu decodieren, so erhält man einen Fehler, da das am Anfang des Rahmens zu erwartende Sync-Wort offenbar nicht auftritt.

Normalerweise schalten Decoder dann in einen Fehler-Recovery-Modus und beginnen mit einer neuen aufwändigen Suche nach einem Sync-Wort. Dadurch entsteht typischerweise eine Fehlstelle im dekodierten Ausgangssignal.

In Fig. 2 ist der erste Rahmen um eine Einheit SL länger als der zweite Rahmen, d.h. L+1 Bytes. Wird die Dekodierung dort begonnen, wohin der Pointer LPOI für die berechnete und abgerundete Größe L weist, so wird dort kein Syncwort gefunden. Deswegen wird eine Einheit SL weiter überprüft, ob ein Syncwort vorhanden ist, und dieses Syncwort wird dort gefunden.

Erfindungsgemäß wird daher vorgeschlagen, bei der Dekodierung von encodierten Signalen mit der Abtastfrequenz 44100Hz oder 22050Hz:

- das Padding-Bit nicht zu speichern oder auszuwerten;
- den ungefähren Beginn des nächsten Rahmens anhand der Formel (1) zu bestimmen;

- das Ergebnis aus (1) auf die nächste ganze Zahl abzurunden;
- beim nachfolgenden Rahmen zunächst festzustellen, ob das erwartete Syncwort oder ein anderes bekanntes Datenmuster auftritt;
- wenn dies der Fall ist, diesen nachfolgenden Rahmen ohne Berücksichtigung des Padding-Bits zu decodieren;
- wenn dies nicht der Fall ist, die Decodierung dieses nachfolgenden Rahmens ohne Berücksichtigung des Padding-Bits einen Slot später zu beginnen.

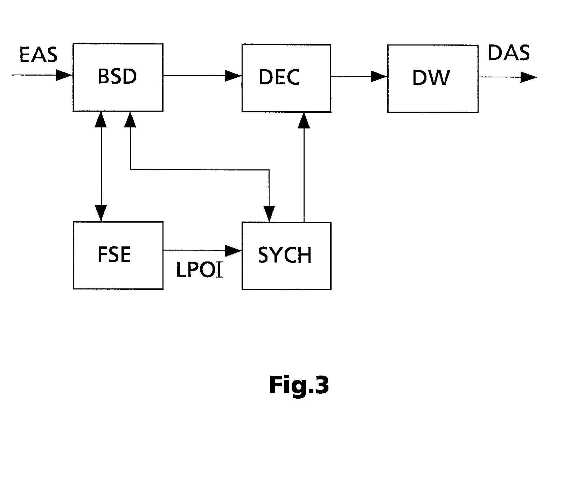

Fig. 3 zeigt einen erfindungsgemäßen Decoder, der ein codiertes Audiosignal EAS empfängt, welches einem Bitstream-Deformatierer BSD zugeführt wird. BSD tauscht entsprechende Daten mit einem Framestart-Schätzer FSE aus. Mit der dort geschätzten Framestart-Adresse bzw. einem entsprechenden Pointer LPOI wird in einem Synchwort-Checker SYCH festgestellt, ob an der entsprechenden Stelle im Datenstrom ein Synchwort vorhanden ist. Falls dies zutrifft, erhält eine Decoder-Stufe DEC und/oder der Bitstream-Deformatierer BSD die Information, die bewirkt, dass die Weiterverarbeitung bzw. Decodierung des nächsten Datenrahmens dort beginnt. Das im Frequenzbereich decodierte Audiosignal wird von der Decoder-Stufe DEC einer Fensterungs-Stufe DW zugeführt, die Abschnitte des Audiosignals z.B. mit einem Synthesefilter multipliziert und in den Zeitbereich überführt und ein decodiertes Audiosignal DAS abgibt.

Die Erfindung kann auch bei verwandten Anwendungen zum Einsatz kommen, bei denen aufgrund eines nicht-ganzen Ergebnisses aus (1) eine Variation der Rahmenlänge erfolgt und mit einer 'Padding-Bit'-ähnlichen Information angezeigt wird.

## Patentansprüche

1. Verfahren zur Decodierung (BSD, DEC, DW) eines codierten digitalen Audio-Signals (EAS) welches in Header (Hd) enthaltende Rahmen angeordnet ist, wobei der Header eines Rahmens jeweils eine Information darüber enthält, ob dieser Rahmen eine Standard-Länge (L) oder eine bei manchen der Rahmen davon abweichender Länge (L+1) hat, und wobei die Rahmen jeweils ein Syncwort (SY) enthalten, **gekennzeichnet durch** folgende Schritte:

   - die Längenvariations-Information über die jeweilige Rahmenlänge wird nicht gespeichert oder ausgewertet;
   - der ungefähre Beginn des nächsten Rahmens wird anhand der folgenden Formel bestimmt (FSE) :

   $$L = N * R / fs / SL,$$

   mit L gleich Länge der Rahmen, N gleich Anzahl der Abtastwerte pro Rahmen, R gleich Gesamt-Datenrate, fs gleich Abtastfrequenz, SL gleich festgelegte Unter-Einheit für die Angabe der Rahmenlänge;

   - L wird auf die nächste ganze Zahl von Unter-Einheiten SL abgerundet (FSE) ;
   - beim nachfolgenden Rahmen wird zunächst festgestellt (SYCH), ob das erwartete Syncwort dieses Rahmens auftritt;
   - wenn das erwartete Syncwort dieses Rahmens auftritt, wird dieser nachfolgende Rahmen ohne Berücksichtigung der Längenvariations-Information decodiert (DEC, DW);
   - wenn das erwartete Syncwort dieses Rahmens nicht auftritt, wird die Decodierung (DEC, DW) dieses nachfolgenden Rahmens ohne Berücksichtigung der Längenvariations-Information eine Unter-Einheit SL später begonnen.

2. Verfahren nach Anspruch 1, wobei die Parameter zum Berechnen der Formel für den ungefähren Rahmen-Beginn aus bekannten Parametern eines Übertragungssystems bestehen.

3. Verfahren nach Anspruch 2, wobei wenigstens einer der Parameter im Header von Rahmen übertragen wird.

4. Verfahren nach einem der Ansprüche 1 bis 3, wobei statt der Feststellung, ob ein erwartetes Syncwort auftritt, eine Feststellung getroffen wird, ob ein anderes bekanntes Muster im folgenden Rahmen auftritt.

5. Vorrichtung zur Decodierung eines codierten digitalen Audio-Signals (EAS) welches in Header (Hd) enthaltende Rahmen angeordnet ist, wobei der Header eines Rahmens jeweils eine Information darüber enthält, ob dieser Rahmen eine Standard-Länge (L) oder eine bei manchen der Rahmen davon abweichender Länge (L+1) hat, und die Rahmen jeweils ein Syncwort (SY) enthalten, wobei für die Ermittlung der Rahmenlänge die Längenvariations-Information über die jeweilige Rahmenlänge nicht gespeichert oder ausgewertet wird und wobei die Vorrichtung enthält:

   - Mittel (BSD, DEC, DW) zur Decodierung des Audio-Signals (EAS) ;
   - einen Rahmenstart-Schätzer (FSE) in dem der ungefähre Beginn des nächsten Rahmens anhand der folgenden Formel bestimmt wird:

   $$L = N * R / fs / SL,$$

   mit L gleich Länge der Rahmen, N gleich Anzahl der Abtastwerte pro Rahmen, R gleich Gesamt-Datenrate, fs gleich Abtastfrequenz, SL gleich festgelegte Unter-Einheit,
und in dem L auf die nächste ganze Zahl von Unter-Einheiten SL abgerundet wird;

- einen Synchwort-Checker (SYCH), der beim nachfolgenden Rahmen zunächst feststellt, ob das erwartete Syncwort dieses Rahmens auftritt, wobei, wenn das erwartete Syncwort dieses Rahmens auftritt, dieser nachfolgende Rahmen ohne Berücksichtigung der Längenvariations-Information in den Decodierungs-Mitteln decodiert wird, und wenn das erwartete Syncwort dieses Rahmens nicht auftritt, die Decodierung dieses nachfolgenden Rahmens ohne Berücksichtigung der Längenvariations-Information in den Decodierungs-Mitteln eine Unter-Einheit SL später begonnen wird.

Fig.1

Fig.2

EP 1 308 931 A1

**Fig.3**

**Europäisches Patentamt**

## EUROPÄISCHER RECHERCHENBERICHT

Nummer der Anmeldung

EP 02 09 0082

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,X | EP 0 402 973 A (KONINKL PHILIPS ELECTRONICS NV) 19. Dezember 1990 (1990-12-19) * Spalte 9, Zeile 34 - Zeile 52 * * Spalte 2, Zeile 38 - Spalte 3, Zeile 10 * * Spalte 3, Zeile 33 - Zeile 43 * * Spalte 12, Zeile 26 - Zeile 32 * * Spalte 17, Zeile 16 - Zeile 57 * --- | 1-5 | G10L19/14 |
| A | WO 00 51243 A (PARK JUNG JAE ;YOU SOO GEUN (KR)) 31. August 2000 (2000-08-31) * Seite 12, Zeile 13 - Seite 13, Zeile 12 * ----- | 1,5 | |

| | |
|---|---|
| | RECHERCHIERTE SACHGEBIETE (Int.Cl.7) |
| | G10L H04B G11B |

Der vorliegende Recherchenbericht wurde für alle Patentansprüche erstellt

| Recherchenort | Abschlußdatum der Recherche | Prüfer |
|---|---|---|
| DEN HAAG | 22. Januar 2003 | Ramos Sánchez, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 02 09 0082

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-01-2003

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0402973 | A | 19-12-1990 | NL | 8901402 | A | 02-01-1991 |
| | | | NL | 9000338 | A | 02-01-1991 |
| | | | AT | 114862 | T | 15-12-1994 |
| | | | AT | 211329 | T | 15-01-2002 |
| | | | AT | 206253 | T | 15-10-2001 |
| | | | AT | 192885 | T | 15-05-2000 |
| | | | AT | 206254 | T | 15-10-2001 |
| | | | AU | 641654 | B2 | 30-09-1993 |
| | | | AU | 5615990 | A | 06-12-1990 |
| | | | BR | 9002617 | A | 20-08-1991 |
| | | | CA | 2017935 | A1 | 02-12-1990 |
| | | | CN | 1048473 | A ,B | 09-01-1991 |
| | | | CN | 1096618 | A | 21-12-1994 |
| | | | CN | 1096619 | A | 21-12-1994 |
| | | | CS | 9002678 | A2 | 15-10-1991 |
| | | | DE | 69014422 | D1 | 12-01-1995 |
| | | | DE | 69014422 | T2 | 14-06-1995 |
| | | | DE | 69033543 | D1 | 15-06-2000 |
| | | | DE | 69033543 | T2 | 04-01-2001 |
| | | | DE | 69033811 | D1 | 31-10-2001 |
| | | | DE | 69033811 | T2 | 13-06-2002 |
| | | | DE | 69033813 | D1 | 31-10-2001 |
| | | | DE | 69033813 | T2 | 13-06-2002 |
| | | | DE | 69033882 | D1 | 31-01-2002 |
| | | | DE | 69033882 | T2 | 12-09-2002 |
| | | | DK | 402973 | T3 | 01-05-1995 |
| | | | DK | 599824 | T3 | 15-04-2002 |
| | | | DK | 599825 | T3 | 21-01-2002 |
| | | | DK | 660540 | T3 | 11-09-2000 |
| | | | DK | 708533 | T3 | 21-01-2002 |
| | | | EP | 0402973 | A1 | 19-12-1990 |
| | | | EP | 0599824 | A2 | 01-06-1994 |
| | | | EP | 0599825 | A2 | 01-06-1994 |
| | | | EP | 0660540 | A2 | 28-06-1995 |
| | | | EP | 0708533 | A2 | 24-04-1996 |
| | | | EP | 0751520 | A2 | 02-01-1997 |
| | | | EP | 0949763 | A2 | 13-10-1999 |
| | | | ES | 2066954 | T3 | 16-03-1995 |
| | | | ES | 2171164 | T3 | 01-09-2002 |
| | | | ES | 2164683 | T3 | 01-03-2002 |
| | | | ES | 2148418 | T3 | 16-10-2000 |
| | | | ES | 2164825 | T3 | 01-03-2002 |
| | | | GR | 3015050 | T3 | 31-05-1995 |
| | | | GR | 3033847 | T3 | 31-10-2000 |
| | | | HK | 41696 | A | 15-03-1996 |
| | | | HK | 1013743 | A1 | 24-11-2000 |

Für nähere Einzelheiten zu diesem Anhang : siehe Amtsblatt des Europäischen Patentamts, Nr.12/82

EPO FORM P0461

**ANHANG ZUM EUROPÄISCHEN RECHERCHENBERICHT**
**ÜBER DIE EUROPÄISCHE PATENTANMELDUNG NR.**   EP 02 09 0082

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-01-2003

| Im Recherchenbericht angeführtes Patentdokument | Datum der Veröffentlichung | Mitglied(er) der Patentfamilie | Datum der Veröffentlichung |
|---|---|---|---|
| EP 0402973 A | | HU   58435 A2 | 28-02-1992 |
| | | JP 3012849 B2 | 28-02-2000 |
| | | JP 3024834 A | 01-02-1991 |
| | | KR   149862 B1 | 15-05-1999 |
| WO 0051243 A | 31-08-2000 | KR 2000056661 A | 15-09-2000 |
| | | AU 1693400 A | 14-09-2000 |
| | | JP 2002538503 A | 12-11-2002 |
| | | WO   0051243 A1 | 31-08-2000 |

EPO FORM P0461

Für nähere Einzelheiten zu diesem Anhang : siehe Amtsblatt des Europäischen Patentamts, Nr.12/82